# EUROPÄISCHE PATENTANMELDUNG

(11) **EP 1 432 124 A2**
(43) Veröffentlichungstag der Anmeldung: **23.06.2004**
(21) Anmeldenummer: 03292909.3
(22) Anmeldetag: 21.11.2003
(51) Int. Cl.: H03K 17/955

(54) **Anordnung zur Signalübertragung zwischen einem Sender und einer Steuereinheit**

(30) Priorität: 18.12.2002 DE 10259124
(71) Anmelder: Nexans, 75008 Paris (FR)
(72) Erfinder: Schröer, Frank, 92637 Weiden (DE); Huscher, Rainer, 95679 Waldershof (DE)
(74) Vertreter: Döring, Roger, Dipl.-Ing.

(57) **Zusammenfassung**

Es wird eine Anordnung zur Signalübertragung zwischen einem Sender und einer Steuereinheit angegeben, bei welcher der Sender eine an eine elektrische Spannungsquelle anschließbare elektronische Schaltung, die durch an dieselbe angeschlossene elektrische Leitungen (13,14) mit der Spannungsquelle und der Steuereinheit verbindbar ist, sowie eine der Schaltung zugeordnete, als Sensor wirkende metallische Platte (16) aus elektrisch gut leitendem Material aufweist. Die elektronische Schaltung ist feuchtigkeitsdicht in einem aus Kunststoff bestehenden Gehäuse (G) angebracht, in welches die Leitungen (13,14) feuchtigkeitsdicht hineingeführt sind. Die Platte (16) ist in einer nach außen offenen, in einer Wandung des Gehäuses (G) befindlichen Vertiefung angeordnet und auf ihrer außen liegenden, plan ausgeführten Oberfläche durch eine Schicht (18) aus schmiegsamem Isoliermaterial feuchtigkeitsdicht abgedeckt, die dicht und spaltfrei an der Platte (16) anliegt.

## Beschreibung

Die Erfindung bezieht sich auf eine Anordnung zur Signalübertragung zwischen einem Sender und einer Steuereinheit, bei welcher der Sender eine an eine elektrische Spannungsquelle anschließbare elektronische Schaltung, die durch an dieselbe angeschlossene elektrische Leitungen mit der Spannungsquelle und der Steuereinheit verbindbar ist, sowie eine der Schaltung zugeordnete, als Sensor wirkende metallische Platte aus elektrisch gut leitendem Material aufweist.

Eine solche Anordnung wird beispielsweise bei Kraftfahrzeugen eingesetzt. Sie kann bei Berührung oder Annäherung einer Hand einer Bedienungsperson eine vorgegebene Funktion auslösen. Ein mögliches Einsatzgebiet einer derartigen Anordnung sind beispielsweise die Türen von Kabrioletts, deren Türscheiben in der Schließstellung aus Stabilitätsgründen bis in das Dach des Fahrzeugs hineinragen. Vor dem Öffnen einer Tür ist es daher erforderlich, die jeweilige Türscheibe so weit abzusenken, daß sie nicht mehr in das Dach eingreift.

Dafür geeignete und auf dem Markt erhältliche Anordnungen sind bekannt. Sie werden in bekannter Technik so in der Griffmulde der Türen eines Kraftfahrzeugs in dieselben eingebaut, daß sie bei Annäherung einer Hand des Fahrzeugführers oder bei Berührung durch dessen Hand ansprechen, so daß die betreffende Türscheibe um eine vorgegebene Strecke nach unten bewegt wird. Das geschieht über ein zu einer Steuereinheit übertragenes Signal, welche einen mit der Türscheibe verbundenen Motor ansteuert. Die Anordnung ist dazu mit einem Sensor und einer Elektronik ausgerüstet, welche durch die am Türgriff anliegende Hand das Signal auslöst. Schwierigkeiten können sich bei diesen Anordnungen durch den Einfluß der Witterung ergeben, weil insbesondere Feuchtigkeit an und in Fahrzeugtüren kaum zu vermeiden ist. Das kann zu Störungen der Elektronik führen.

Der Erfindung liegt die Aufgabe zugrunde, die eingangs geschilderte Anordnung so zu gestalten, daß sie auf einfache Weise feuchtigkeitsdicht ausgeführt werden kann.

Diese Aufgabe wird gemäß der Erfindung dadurch gelöst,
- daß die elektronische Schaltung feuchtigkeitsdicht in einem aus Kunststoff bestehenden Gehäuse angebracht ist, in welches die Leitungen feuchtigkeitsdicht hineingeführt sind, und
- daß die Platte in einer nach außen offenen, in einer Wandung des Gehäuses befindlichen Vertiefung angeordnet und auf ihrer außen liegenden, plan ausgeführten Oberfläche durch eine Schicht aus schmiegsamem Isoliermaterial feuchtigkeitsdicht abgedeckt ist, die dicht und spaltfrei an der Platte anliegt.

In dieser Anordnung kann eine elektronische Schaltung verwendet werden, auf welcher die elektronischen Bauteile in üblicher Technik beispielsweise auf einer Leiterkarte angeordnet sind. Die elektronische Schaltung ist in dem aus Kunststoff bestehenden Gehäuse insgesamt feuchtigkeitsdicht untergebracht, so daß keine zusätzlichen Maßnahmen zum Schutz ihrer elektronischen Bauteile gegenüber Feuchtigkeit erforderlich sind. Das gilt auch für die mit der Schaltung verbundene, mit einer elektrischen Spannung beaufschlagte metallische Platte, welche in einer Wandung des Gehäuses so angeordnet ist, daß sie von außen zugänglich ist. Ihre plane, nach außen weisende Oberfläche ist durch schmiegsames Isoliermaterial einerseits feuchtigkeitsdicht und andererseits spaltfrei abgedeckt, so daß sie gegenüber einer sich nähernden Hand reproduzierbare Eigenschaften hat, die nicht durch Lufteinschlüsse verfälscht werden.

Die Vertiefung zur Aufnahme der Platte ist mit Vorteil eine Durchbrechung der Wandung des Gehäuses. Schaltung bzw. Leiterkarte und Platte können im Wege der Vorfertigung miteinander verbunden und als Einheit in das Gehäuse eingesetzt werden. Auch die Leitungen können vorher bereits an die Schaltung angeschlossen sein.

Ein Ausführungsbeispiel des Erfindungsgegenstandes ist in den Zeichnungen dargestellt.

Es zeigen:
Fig. 1 in schematischer Darstellung eine Seitenansicht eines Personenkraftwagens.
Fig. 2 einen Schnitt durch eine Tür des Personenkraftwagens nach Fig. 1 längs der Linie II - II in vergrößerter Darstellung.
Fig. 3 bis 5 unterschiedliche Ansichten der Anordnung nach der Erfindung in weiter vergrößerten Darstellungen.

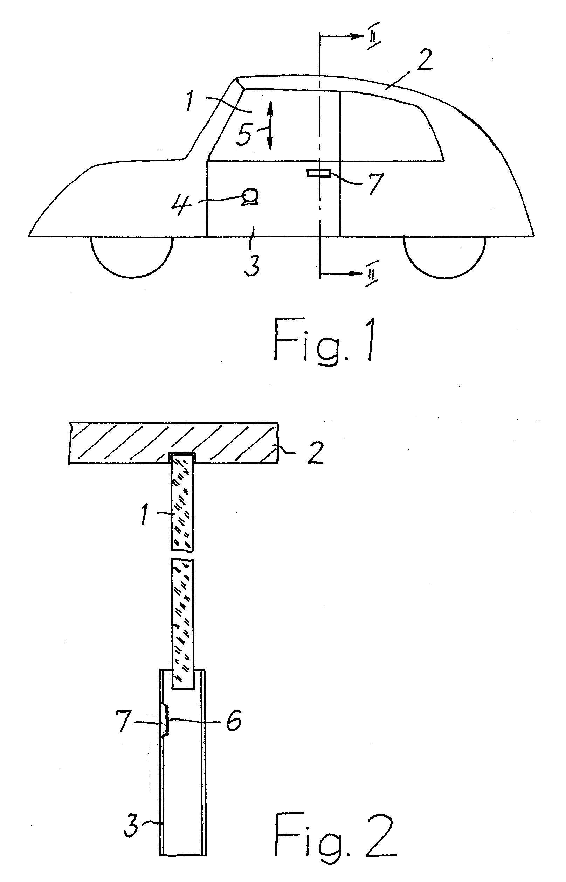

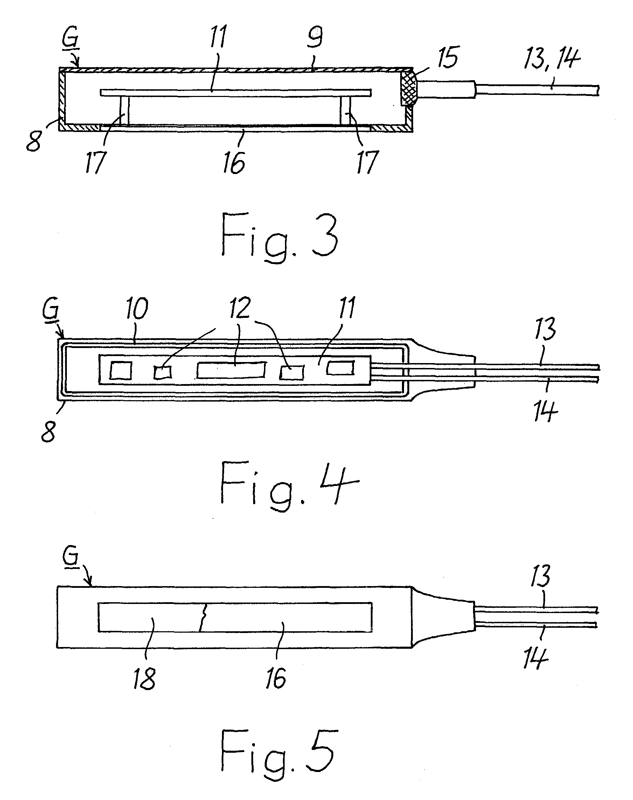

Bei dem in Fig. 1 dargestellten Personenkraftwagens (PKW) soll es sich um ein Kabriolett handeln, dessen Türscheiben keinen eigenen Rahmen haben. Bei geschlossener Türscheibe 1 greift dieselbe in das Verdeck 2 des PKWs ein, damit derselbe stabil verschlossen ist. Die Türscheibe 1 ist mittels eines elektrisch angetriebenen, in der Tür 3 des PKWs angeordneten Motors 4 in Richtung des Doppelpfeils 5 verstellbar. Sie kann mittels einer in den Fig. 3 bis 5 genauer dargestellten Anordnung 6 um eine kurze Strecke nach unten bewegt werden, damit sie nicht mehr in das Verdeck 2 eingreift. Die Tür 3 kann dann geöffnet werden. Die Anordnung 6 ist beispielsweise im Bereich einer Griffmulde 7 in der Tür 3 des PKWs angebracht (Fig. 2).

Die Anordnung 6 kann beispielsweise vom Fahrer des PKWs betätigt werden. Damit sie wirksam wird, muß der Fahrer vorher ein Signal senden, mit dem beispielsweise auch die sonstige Elektronik des PKWs aktiviert wird. Ein entsprechender Sender ist üblicherweise im Griff des Fahrzeugschlüssels integriert.

Die Anordnung 6 besteht aus einem Gehäuse G aus mechanisch stabilem Kunststoff, wie beispielsweise Polyamid, das einen kastenförmigen Bodenteil 8 und einen Deckel 9 aufweist. Bei auf den Bodenteil 8 aufgesetztem Deckel 9 ist das Gehäuse G feuchtigkeitsdicht verschlossen. Dazu kann zwischen beiden Teilen eine umlaufende Dichtung 10 vorhanden sein, die mit Vorteil in einer entsprechenden Nut des Bodenteils 8 angebracht ist.

Im Gehäuse G ist eine elektronische Schaltung 11 angeordnet, deren nur schematisch angedeutete Bauteile 12 vorzugsweise auf einer Leiterkarte angebracht sind. An die elektronische Schaltung 11 sind elektrische Leitungen 13 und 14 angeschlossen, von denen eine mit einer im PKW vorhandenen Spannungsquelle, beispielsweise der Fahrzeugbatterie, und die andere mit einer ebenfalls im PKW vorhandenen Steuereinheit verbunden ist. Im Einführungsbereich der Leitungen 13 und 14 in das Gehäuse G ist in einer Aussparung desselben ein Dichtungselement 15 angebracht, das diesen Einführungsbereich feuchtigkeitsdicht verschließt.

Im Gehäuse G ist außerdem eine aus elektrisch gut leitendem Material bestehende metallische Platte 16 angebracht, die als Sensor wirkt. Sie ist elektrisch leitend mit der elektronischen Schaltung 11 verbunden und dadurch mit einer elektrischen Spannung beaufschlagt. Platte 16 und Schaltung 11 bilden zusammen den Sender der Anordnung 6. Beide Teile können mittels Stützen 17 mechanisch zu einer Einheit miteinander verbunden sein. Die Platte 16 ist im dargestellten Ausführungsbeispiel in einer nach außen offenen, in einer Wandung des Gehäuses G befindlichen Vertiefung angebracht, die sich vorzugsweise in dessen Bodenteil 8 befindet. Sie liegt damit gemäß Fig. 5 von außen zugänglich im Gehäuse G. Die Platte 16 ist in der Wandung des Gehäuses G feuchtigkeitsdicht angebracht. An der äußeren, plan ausgeführten Oberfläche der Platte 16 liegt außerdem eine Schicht 18 aus schmiegsamem Isoliermaterial dicht und spaltfrei an. Sie dient einerseits zur feuchtigkeitsdichten Abdeckung der Platte 16 und andererseits als Berührungsschutz. Die Schicht 18 besteht beispielsweise aus einem thermoplastischen Polymer.

Die Anordnung 6 nach der Erfindung arbeitet beispielsweise wie folgt:

Die fertig montierte Anordnung 6, also das feuchtigkeitsdicht verschlossene Gehäuse G, wird im Bereich der Griffmulde 7 in der Tür 3 eines PKWs montiert. Die Platte 16 liegt dann auf der der Türmulde 7 zugewandten Seite. Die Tür 3 kann in der Türmulde 7 eine Durchbrechung aufweisen, welche der Größe der Platte 16 entspricht. Die elektronische Schaltung 11 ist in der Montageposition über die Leitungen 13 und 14 mit der Spannungsquelle und der Steuereinheit des PKWs verbunden.

Damit die Tür 3 des PKWs geöffnet werden kann, muß die Türscheibe 1 so weit nach unten bewegt werden, daß sie nicht mehr in das Verdeck 2 eingreift. Dazu wird die Anordnung 6 und damit deren Sender zunächst durch ein vom Fahrer ausgelöstes Signal aktiviert. Wenn dann der Fahrer seine Hand in die Nähe der Platte 16 bringt, was auch die Berührung der die Platte 16 abdeckenden Schicht 18 einschließt, wird die Kapazität des aus Platte 16 und Schaltung 11 bestehenden Senders verändert. Der Sender schickt ein entsprechendes Signal an die Steuereinheit des PKWs, von welcher der Motor 4 zur Absenkung der Türscheibe 1 solange eingeschaltet wird, bis dieselbe nicht mehr in das Verdeck 2 eingreift. Die Tür 3 kann dann geöffnet werden. Durch die spaltfreie Abdeckung der Platte 16 ist sichergestellt, daß die jeweilige Kapazitätsänderung in engen Grenzen bei gleichen Werten liegt.

Die Anordnung nach der Erfindung ist im Ausführungsbeispiel als "Türöffner" geschildert. Sie läßt sich aber in einem Kraftfahrzeug auch für andere sinnvolle Zwecke einsetzen, beispielsweise zur Sitzverstellung.

## Patentansprüche

1. Anordnung zur Signalübertragung zwischen einem Sender und einer Steuereinheit, bei welcher der Sender eine an eine elektrische Spannungsquelle anschließbare elektronische Schaltung, die durch an dieselbe angeschlossene elektrische Leitungen mit der Spannungsquelle und der Steuereinheit verbindbar ist, sowie eine der Schaltung zugeordnete, als Sensor wirkende metallische Platte aus elektrisch gut leitendem Material aufweist, **dadurch gekennzeichnet,**
- **daß** die elektronische Schaltung (11) feuchtigkeitsdicht in einem aus Kunststoff bestehenden Gehäuse (G) angebracht ist, in welches die Leitungen (13,14) feuchtigkeitsdicht hineingeführt sind, und
- **daß** die Platte (16) in einer nach außen offenen, in einer Wandung des Gehäuses (G) befindlichen Vertiefung angeordnet und auf ihrer außen liegenden, plan ausgeführten Oberfläche durch eine Schicht (18) aus schmiegsamem Isoliermaterial feuchtigkeitsdicht abgedeckt ist, die dicht und spaltfrei an der Platte (16) anliegt.

2. Anordnung nach Anspruch 1, **dadurch gekennzeichnet, daß** die elektronische Schaltung (11) auf einer Leiterkarte angebracht ist.

3. Anordnung nach Anspruch 1 oder 2, **dadurch gekennzeichnet, daß** das Gehäuse (G) aus einem kastenförmigen Bodenteil (8) und einem Deckel (9) besteht, zwischen denen eine umlaufende Dichtung (10) angebracht ist.

4. Anordnung nach Anspruch 3, **dadurch gekennzeichnet, daß** der Bodenteil (8) eine Aussparung aufweist, in welcher ein die Leitungen (13,14) feuchtigkeitsdicht umschließendes Dichtelement (15) angebracht ist.

5. Anordnung nach einem der Ansprüche 1 bis 4, **dadurch gekennzeichnet, daß** die Wandung des Gehäuses (G) zur Bildung der die Platte (16) aufnehmenden Vertiefung vollständig durchbrochen ist.
